# EUROPÄISCHE PATENTSCHRIFT

(11) **EP 4 143 587 B1**
(45) Veröffentlichungstag und Bekanntmachung des Hinweises auf die Patenterteilung: **03.04.2024**
(21) Anmeldenummer: 21746403.1
(22) Anmeldetag: 14.07.2021
(51) Int. Cl.: G01R 15/20

(54) **STROMMESSVORRICHTUNG MIT HALLSENSOREN**
CURRENT MEASURING DEVICE WITH HALL SENSORS
DISPOSITIF DE MESURE DE COURANT POURVU DE CAPTEURS HALL

(30) Priorität: 18.08.2020 EP 20191477
(43) Veröffentlichungstag der Anmeldung: 08.03.2023
(73) Patentinhaber: Siemens Aktiengesellschaft, 80333 München (DE)
(72) Erfinder: WEISS, Roland, 91058 Erlangen (DE); CHAHID, Abderrahim, 91334 Hemhofen (DE); FLEISCH, Karl, 91054 Erlangen (DE); HOFFMANN, Ingolf, 91074 Herzogenaurach (DE); ITZKE, Alexander, 90443 Nürnberg (DE); SCHNIEDERS, Anja, 91056 Erlangen (DE); ZAPF, Florian, 91054 Buckenhof (DE)
(74) Vertreter: Siemens Patent Attorneys
(86) Internationale Anmeldenummer: PCT/EP2021/069640
(87) Internationale Veröffentlichungsnummer: WO 2022/037854

(56) Entgegenhaltungen:
- EP-A1- 0 548 391
- CN-A- 103 308 075
- CN-B- 104 395 765
- CN-U- 204 526 866
- CN-U- 206 834 784
- DE-A1- 3 901 792
- DE-A1- 19 914 772
- DE-A1-102014 108 587
- KR-A- 20110 009 910
- US-A1- 2004 239 207
- US-A1- 2005 156 587
- US-A1- 2007 229 050
- SCOVILLE J T ET AL: "A LOW-COST MULTIPLE HALL PROBE CURRENT TRANSDUCER", REVIEW OF SCIENTIFIC INSTRUMENTS, AIP, MELVILLE, NY, US, Bd. 62, Nr. 3, 1. März 1991 (1991-03-01), Seiten 755-760, XP000224321, ISSN: 0034-6748, DOI: 10.1063/1.1142080

## Beschreibung

Die Erfindung betrifft eine Strommessvorrichtung zur Erzeugung eines zu einem zu messenden Strom proportionalen Ausgangsstroms. Ferner betrifft die Erfindung einen Stromrichter mit einer derartigen Strommessvorrichtung. Die Erfindung betrifft weiter ein Verfahren zur Messung eines zu messenden Stroms mit einer derartigen Messvorrichtung oder eines derartigen Stromrichters.

Heutzutage sind eine Vielzahl von Strommessvorrichtungen bekannt. Für die Messung von Wechselströmen kann auf einfache Weise ein Transformator genutzt werden. Der durch die Primärwicklung fließende, zu messende Strom wird entsprechend des Übersetzungsverhältnisses, das dem Verhältnis der Windungszahlen entspricht, auf die Sekundärseite übertragen. Dort kann dann ein entsprechend kleinerer, allerdings dem zu messenden Strom proportionaler Strom mittels eines Messaufnehmers erfasst und ausgewertet werden. Die Druckschrift DE 199 14 772 A1 offenbart eine Strommessvorrichtung der auf dem Prinzip der Oberflächenfeldmessung beruht. Die Strommessvorrichtung weist zumindest zwei an einem Leiter angeordneten Hallsensoren auf.

Darüber hinaus gibt es eine Vielzahl weiterer Messverfahren und -anordnungen, die sich das durch den zu messenden Strom erzeugte Magnetfeld zu Nutze machen. Diese können zur Messung sowohl für Wechselstrom als auch Gleichstrom verwendet werden. Allen diesen Anordnungen und Verfahren ist gemeinsam, dass sie äußerst empfindlich sind gegenüber Störungen. Zu den Störungen zählen beispielsweise elektromagnetische Felder, die häufig bei großen elektrischen Komponenten, wie elektrischen Antrieben vorkommen. Gerade in einem Stromrichter kann es zu elektromagnetischer Beeinflussung der Stromsensoren durch die hohen geschalteten Ströme kommen. Auf der anderen Seite ist die Regelung eines Stromrichters auf genau Messwerte von Stromsensoren angewiesen, um den Stromrichter zuverlässig und sicher regeln, steuern und schützen zu können. Bisher wurde vergleichsweise viel Platz im Stromrichter für die Strommessung vorgesehen. Dabei wurden die Stromwandler durch aufwendige magnetische Schirme vom Einfluss des Fremdfeldes, das unter anderem durch den Betrieb des Stromrichters entsteht, abgeschirmt.

Der Erfindung liegt die Aufgabe zugrunde, eine Strommessvorrichtung zu verbessern.

Diese Aufgabe wird durch eine Strommessvorrichtung zur Erzeugung eines zu einem zu messenden Strom proportionalen Ausgangsstroms gelöst, wobei die Strommessvorrichtung mindestens zwei auf einer Kreisbahn angeordnet Hallsensoren umfasst, wobei die Hallsensoren bezogen auf den Mittelpunkt der Kreisbahn gleich ausgerichtet sind, wobei die Strommessvorrichtung eine Addierschaltung zum Summieren von Messignalen der Hallensensoren aufweist, wobei die Strommessvorrichtung eine Subtrahierschaltung zur Beseitigung eines Offsets aufweist, wobei die Strommessvorrichtung eine spannungsgesteuerte Stromquelle aufweist, wobei zur Versorgung der Hallsensoren die Strommessvorrichtung eine Stromversorgungseinrichtung mit einer Toroidspule aufweist, wobei die Stromversorgungseinrichtung einen DC/DC Wandler umfasst, wobei die Toroidspule einen paramagnetischen und/oder diamagnetischen Kern aufweist. Die Erfindung wird weiter durch einen Stromrichter mit einer derartigen Strommessvorrichtung gelöst. Ferner wird die Erfindung durch ein Verfahren zur Messung eines zu messenden Stroms mit einer derartigen Messvorrichtung oder mittels eines derartigen Stromrichters gelöst, wobei in einem ersten Schritt die Messsignale der Hallsensoren mittels der Addierschaltung addiert werden und eine zum zu messenden Strom proportionale Spannung erzeugt wird, wobei in einem zweiten Schritt mittels der Subtrahierschaltung ein Offset derart von der zum zu messenden Strom proportionale Spannung subtrahiert wird, dass sich eine referenzierte Spannung ergibt, bei der die zum zu messenden Strom proportionale Spannung auf eine vorgegebene Bezugsmasse referenziert wird, wobei in einem dritten Schritt mittels der spannungsgesteuerten Stromquelle in Abhängigkeit von der referenzierten Spannung ein Ausgangsstrom mit einem zum zu messenden Strom vorgegebenen Übersetzungsverhältnis erzeugt wird.

Weitere vorteilhafte Ausgestaltungen der Erfindung sind in den abhängigen Ansprüchen angegeben.

Der Erfindung liegt unter anderem die Erkenntnis zugrunde, dass sich ein Stromsensor insbesondere für die Verwendung in einem Stromrichter dadurch verbessern lässt, dass seine Hallsensoren zur Messung des durch den Strom erzeugten Magnetfeldes auf einer Kreisbahn, auch als Kreislinie bezeichnet, angeordnet sind. Dabei sind die Hallsensoren gegenüber dem Mittelpunkt gleich angeordnet. Insbesondere sind die Hallsensoren mit ihrer sensitiven Achse tangential zur Kreisbahn ausgerichtet.

Dabei bilden die Hallsensoren in Kombination mit dem elektronischen System aus Energieversorgung, Addierschaltung, Subtrahierschaltung und spannungsgesteuerter Stromquelle eine zuverlässige, störunempfindliche und kompakte Strommessvorrichtung. Die Komponenten können dabei beispielsweise platzsparend auf einer Platine angeordnet werden.

Zur Anwendung in vielen leistungselektronischen Systemen, jedoch auch zum Einsatz in Systemen zur Verteilung von elektrischer Energie, ist es vorteilhaft oder notwendig, dass der Stromsensor in Form eines Stromwandler ausgeführt ist. Dies bedeutet, dass das Ausgangssignal des Stromsensors ein Strom (ein so genannter Sekundärstrom) ist, welcher sich direkt proportional zum Messstrom (Primärstrom) verhält. Da diese auf elektronischem Wege erzeugten Sekundärströme häufig Werte von 1A bis 5A erreichen und sehr hohe Anforderungen in Punkte Genauigkeit, Frequenzgang und Robustheit gegenüber äußeren Störungen wie z.B. sehr hohen Magnetfeldern erfüllen müssen, bestehen sehr hohe Anforderungen an die entsprechende elektrische bzw. elektronische Schaltung.

Eine wesentliche Neuerung im Vergleich zu bekannten Stromsensoren ist der Einsatz von Toroidspulen für die Stromversorgungseinrichtung zum Erzeugen der Versorgungsspannungen der Hallsensoren. Es hat sich gezeigt, dass im Allgemeinen die Hallsensoren mit einer anderen Spannung gespeist werden als die für die Strommessvorrichtung zur Verfügung stehende Versorgungsspannung. Diese von den Hallsensoren benötigte Spannung wird mit Hilfe der Stromversorgungseinrichtung erzeugt. Wichtig ist, dass diese das zu messende Signal, bzw. die zum zu messenden Strom zugehörigen Magnetfelder nicht beeinflusst. Besonders vorteilhaft wirkt sich in diesem Zusammenhand die Toroidspule aus, mit der sich ein störender Einfluss zwischen Stromversorgung und Hallsensoren vermeiden bzw. hinreichend unterdrücken lässt. Darüber hinaus kann mit der Kombination dieser Stromversorgungseinrichtung mit der sehr präzisen potentialfreien spannungsgesteuerten Stromquelle auf Operationsverstärker-Basis mit einer Endstufe vom Typ B ein störunempfindliche Strommessvorrichtung angegeben werden, die sich sowohl zur Messung von Gleichströmen als auch zur Messung von Wechselströmen nach dem Stromwandlerprinzip eignet. Durch die geschlossene Flussführung innerhalb der toroidförmigen Spule wird die wechselseitige Beeinflussung von Stromversorgungseinrichtung und Messfeld beseitigt oder zumindest hinreichend minimiert. Eine besonders genaue Messung des Stroms kann erreicht werden, durch eine Kombination einer potentialfreien, spannungsgesteuerten Stromquelle auf Operationsverstärker-Basis mit einer Transistor-Endstufe des Typs B. Da die Endstufe vom Typ B nicht einfach in Reihe zur spannungsgesteuerten Stromquelle auf OPV-Basis angeordnet ist, sondern optional als integraler Teil der Rückkopplung und damit der Regelung des OPVs ist, wird eine sehr präzise potentialfreie spannungsgesteuerte Stromquelle mit sehr hohem Leistungs-Bandbreite-Produkt und sehr guter räumlicher Verteilung der Verlustleistung erreicht. Die räumliche Aufteilung der Verlustleitung ermöglicht es ebenso, die Abmessungen der kreisförmigen Hallsensoren auf einer Platine auf eine geringe Abmessung zu reduzieren. Hierdurch lassen sich Sensorplatinen realisieren, die platzsparend in Geräten, wie beispielsweise einem Stromrichter, eingesetzt werden können. Damit werden Kundenanforderungen nach immer kleineren Baugrößen erfüllt.

Bei der Anordnung der Magnetfeldsensoren ist es entscheidend, dass diese auf einer Kreislinie, vorzugsweise bei gleichmäßiger Winkelteilung, erfolgt. Darüber hinaus muss die Ausrichtung der Hallsensoren vom Mittelpunkt der Kreislinie aus gesehen gleichartig sein. Verzugsweise, zur Erhöhung der Empfindlichkeit und damit der Genauigkeit der Strommessvorrichtung ist die sensitive Achse der Sensoren tangential zur Kreislinie ausgerichtet. Über eine analogelektronische Addierschaltung wird aus den einzelnen Signalen der Magnetfeldsensoren die Näherung des ampereschen Gesetzes gebildet und so eine zum Strom proportionale Messspannung erzeugt. Im nächsten Schritt wird durch eine analogelektronische Subtrahiererschaltung ein bestehender Offset abgezogen und das Messignal dadurch auf eine vorgegebene Bezugsmasse Masse referenziert. Dieses Signal, die referenzierte Spannung, wird im Anschluss über die bereits beschriebene spannungsgesteuerte Stromquelle in einen zum Messstrom proportionalen Ausgangsstrom mit festen Übersetzungsverhältnis zum Messstrom umgewandelt. Auf diese Weise wird ein rein elektronisch arbeitender Stromwandler ohne aktiven magnetischen Flusskreis erzeugt. Durch die Verwendung der analogen Schaltungen treten keine Totzeiten im System auf und die Strommessvorrichtung arbeitet genau in Hinblick auf Stromhöhe und unverzögert, zumindest nahezu unverzögert, zum Messsignal.

Besonders vorteilhaft ist es, dass die vorgeschlagene Strommessvorrichtung zur Messung von Gleichstrom und Wechselstrom geeignet ist. Bisher bekannte transformatorische Wandler zur Durchführung des Stromwandlerprinzips sind aufgrund des dort verwendeten Magnetfeldes und Sättigungseffekten nur für die Messung von Wechselstrom geeignet.

Diese beschriebene Anordnung und das Verfahren eignen sich im Besonderen von seinen Abmessungen und den verwendeten Komponenten zur Messung von Strömen in der Größenordnung von 400A bis 10kA.

Dabei umfasst die Stromversorgungseinrichtung einen DC/DC Wandler. Durch die Verwendung eines DC/DC-Wandlers wird, verglichen mit einem Linearregler, die Verlustleitung auf etwa 30% reduziert, so dass Entwärmungsprobleme umgangen werden können. Zudem können die für einen DC/DC Wandler erforderlichen magnetischen Bauelemente durch die Verwendung der Toroidspule in die Strommessvorrichtung eingebaut werden, ohne die Magnetfelder des zu messenden Stroms und damit das Messergebnis unzulässig zu beeinflussen. Somit kann eine kostengünstige, zuverlässige und genaue Strommessvorrichtung realisiert werden.

Da die Gesamtschaltung sehr hohen Magnetfeldern ausgesetzt wird und diese Magnetfelder nach Möglichkeit nicht durch die elektronische Schaltung der Stromversorgungseinrichtung beeinflusst werden sollen, ist es vorteilhaft, die für den DC/DC-Wandler notwendigen Spulen, als möglichst gleichmäßig gewickelte Toroidspule auszuführen.

Darüber hinaus weist die Toroidspule einen paramagnetischen und/oder diamagnetischen Kern auf. Durch die Ausbildung der Toroidspule mit einem paramagnetischen und/oder diamagnetischen Kern werden Störfelder weiter reduziert und die Genauigkeit der Messvorrichtung weiter erhöht. Durch die Verwendung von ferro- oder ferrimagnetischen Kernmaterialien würde sich zwar auch ein Strom hinreichend genau messen lassen, jedoch durch die Verwendung des paramagnetischen und/oder diamagnetischen Kerns kann die Genauigkeit der Strommessung noch weiter erhöht werden. Des Weiteren ist ein störungsfreier Betrieb des DC/DC Wandlers möglich, der ansonsten aufgrund von Sättigungseffekten bei ferro- oder ferrimagnetischen Kernmaterialien beeinträchtigt sein könnte. Somit ermöglicht erst der Einsatz von ferro- oder ferrimagnetischen Kernmateriealien den störungsfreien Betrieb des DC/DC Wandlers. Somit wird durch die Kombination von ferro- oder ferrimagnetischen Kernmateriealien und dem DC/DC Wandler ein besonders zuverlässiger, störungssicherer und darüber hinaus genauer Stromsensor realisierbar.

Bei einer vorteilhaften Ausgestaltung der Erfindung weist die Strommessvorrichtung mindestens acht Hallsensoren auf. Es hat sich gezeigt, dass durch die Verwendung von acht Hallsensoren ein besonders gutes Verhältnis von Nutzsignal zu Störsignal erreicht werden kann. Diese acht Hallsensoren werden vorteilhafterweise mit einer Winkelteilung von 45° auf der Kreislinie, vorzugsweise auf einer Platine, angeordnet. Selbst wenn der zu messende Strom nicht durch den Mittelpunkt dieser Kreislinie verläuft, lassen sich mit der vorgeschlagenen Anordnung durch die hohe Anzahl von Hallsensoren sehr genau der Strom bestimmen. Der Einfluss von Störgrößen, beispielsweise durch äußere magnetische Felder ist dann derart gering, dass deren Einfluss auf das Messergebnis durch die Addierschaltung kompensiert wird.

Im Folgenden wird die Erfindung anhand der in den Figuren dargestellten Ausführungsbeispiele näher beschrieben und erläutert. Es zeigen:
- FIG 1: eine Platine mit acht Hallsensoren,
- FIG 2: einen Stromrichter und
- FIG 3: ein Schema zur Durchführung der Messung mittels der Strommessvorrichtung

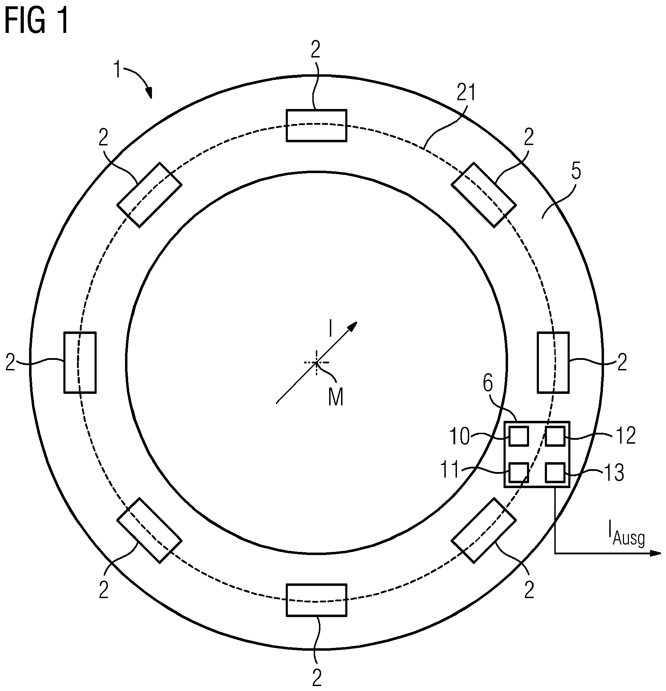

Die FIG 1 zeigt eine Strommessvorrichtung 1. Auf einer Platine 5 sind Hallsensoren 2 auf einer Kreisbahn 21 um einen Mittelpunkt M angeordnet. In diesem Ausführungsbeispiel kommen dabei acht Hallsensoren 2 zum Einsatz. Zur Durchführung des Messverfahrens mittels der vorgeschlagenen Strommessvorrichtung sind jedoch nur mindestens zwei Hallsensoren 2 erforderlich. Je mehr Hallsensoren 2 verwendet werden, desto besser ist das Messergebnis. Die Anzahl von Acht hat sich dabei als guter Kompromiss erwiesen zwischen einer hohen Genauigkeit und einer einfachen, kostengünstigen Messanordnung.

Damit kann ein Strom I gemessen werden, der die durch die Kreisbahn 21 begrenzte Fläche durchdringt. Dabei ist in diesem Ausführungsbeispiel die Platine 5 als Kreisscheibe ausgebildet, um den Strom durch einen hier nicht dargestellten Leiter 7 zu messen, um den herum die Platine 5 angeordnet werden kann. Bezogen auf den Mittelpunkt M der Kreisbahn 21 sind die acht Hallsensoren 2 gleich ausgerichtet. Besonders vorteilhaft ist die Ausrichtung der Hallsensoren 2 mit ihrer sensitiven Achse tangential zur Kreisbahn 21.

Die acht Hallsensoren 2 sind dabei, nicht notwendigerweise, äquidistant auf der Kreisbahn 21 verteilt. Dies ermöglicht jedoch eine genaue Messung des Stromes I, auch wenn dieser nicht durch den Mittelpunkt M der Kreisbahn 21 verläuft. Als Ausgangssignal stellt die Strommessvorrichtung 1 einen zum zu messenden Strom I proportionalen Strom I_{Ausg} zur Verfügung. Dieser wird von der Auswerteeinheit 6 erzeugt, die eine Stromversorgungseinrichtung 10, eine Addierschaltung 11 eine Subtrahierschaltung 12 und eine spannungsgesteuerte Stromquelle 13 umfasst.

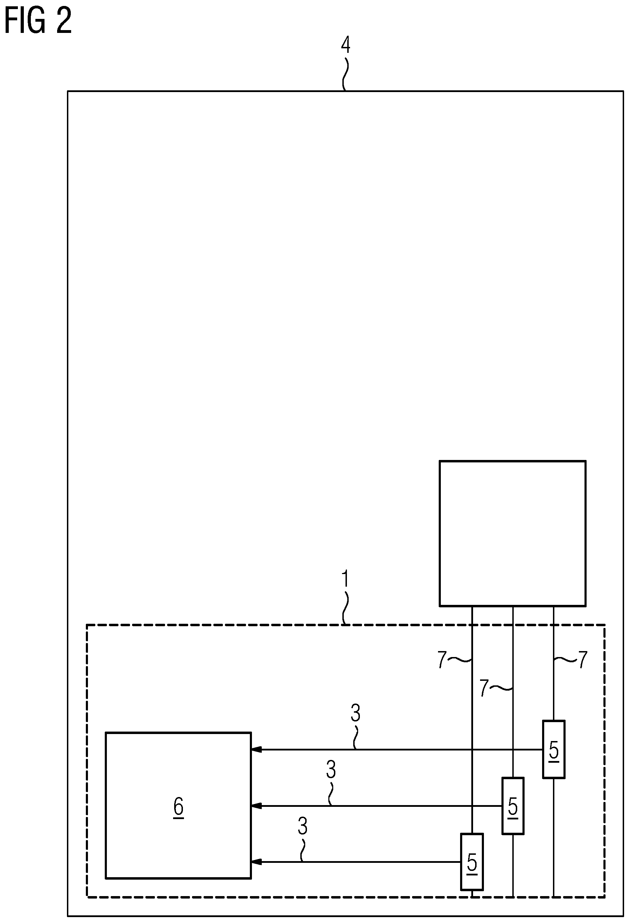

Die Auswerteeinheit 6 kann dabei auf der Platine 5 mit den Hallsensoren 2 angeordnet sein oder sich außerhalb der Platine 6 befinden. Die FIG 2 zeigt einen Stromrichter 4 mit einer vorgeschlagenen Strommessvorrichtung 1 zur Messung von drei Strömen. Dazu sind drei Platinen 5 um entsprechende Leiter 7 angeordnet. Aus Gründen der Übersichtlichkeit wurde auf die Darstellung der Hallsensoren 2 auf den Platinen 5 verzichtet. In diesem Ausführungsbeispiel befindet sich die Auswerteeinheit 6 außerhalb der Platine 5 im Innern des Stromrichters 4.

Die Platinen 5 sind jeweils zur Übertragung der Messignale 3 der Hallsensoren 2 mit der Auswerteeinheit 6 verbunden. Somit stehen für die Regelung und den Schutz des Stromrichters 4 entsprechende Strommesswerte mit hinreichender Genauigkeit zur Verfügung. Darüber hinaus ist die Strommessanordnung 1 derart robust, dass diese auch im Innern des Stromrichters 4, in dem sich elektrische und/oder magnetische Störfelder ausbilden können, ohne besondere Schirmungsmaßnahmen, also ungeschirmt, betrieben werden kann.

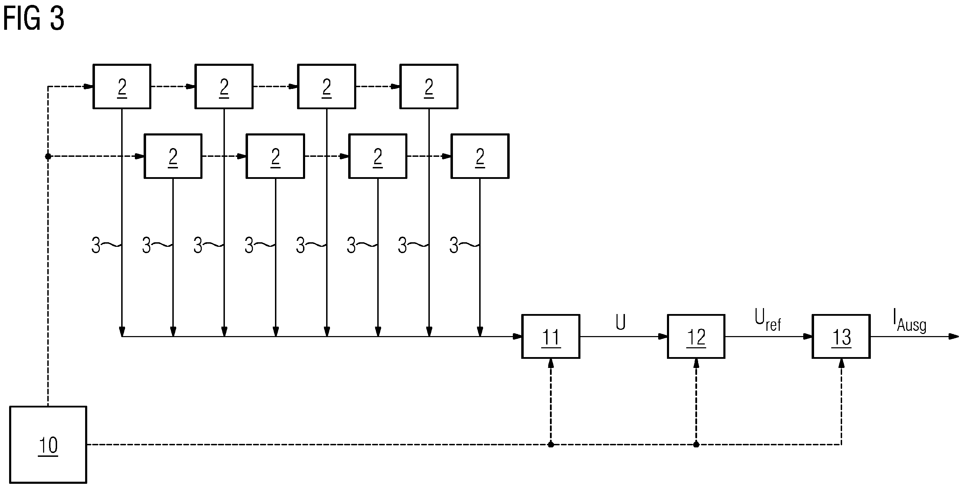

Die FIG 3 zeigt ein Schema des Verfahrens zur Messung eines Stroms I mittels der Strommessvorrichtung 1. Zur Vermeidung von Wiederholungen wird auf die Beschreibung zur den Figuren 1 und 2 sowie auf die dort eingeführten Bezugszeichen verwiesen. Ausgehend vom Aufbau des Ausführungsbeispiels der FIG 1 sind auch hier acht Hallsensoren 2 zur Erfassung des Stroms I vorgesehen. Diese Hallsensoren 2 werden von einer Stromversorgungseinrichtung 10 mit elektrischer Energie versorgt. Die Messsignale 3 der Hallsensoren 2 werden einer Addierschaltung 11 zugeführt. Diese addiert die Messsignale und generiert daraus eine zum zu messenden Strom proportionale Spannung U. Von dieser Spannung U wird ein Offset mittels einer Subtrahierschaltung 12 abgezogen. Die sich ergebende Spannung ist dann auf eine vorgegebene Bezugsmasse bezogen. Man bezeichnet dies auch als auf eine Bezugsmasse referenziert, so dass diese Spannung als referenzierte Spannung U_{ref} bezeichnet wird. Diese wird dann einer spannungsgesteuerten Stromquelle 13 zugeführt, welche die referenzierte Spannung U_{ref} in einen Ausgangsstrom I_{Ausg} umwandelt, der proportional zum zu messenden Strom I ist. Dabei können auch die Addierschaltung 11, die Subtrahierschaltung 12 und die spannungsgesteuerte Stromquelle 13 von der Stromversorgungseinrichtung 10 mit elektrischer Energie versorgt werden.

Zusammenfassend betrifft die Erfindung eine Strommessvorrichtung zur Erzeugung eines zu einem zu messenden Strom proportionalen Ausgangsstroms. Zur Verbesserung der Strommessvorrichtung wird vorgeschlagen, dass die Strommessvorrichtung mindestens zwei auf einer Kreisbahn angeordnet Hallsensoren umfasst, wobei die Hallsensoren bezogen auf den Mittelpunkt der Kreisbahn gleich ausgerichtet sind, wobei die Strommessvorrichtung eine Addierschaltung zum Summieren von Messignalen der Hallensensoren aufweist, wobei die Strommessvorrichtung eine Subtrahierschaltung zur Beseitigung eines Offsets aufweist, wobei die Strommessvorrichtung eine spannungsgesteuerte Stromquelle aufweist, wobei zur Versorgung der Hallsensoren die Strommessvorrichtung eine Stromversorgungseinrichtung mit einer Toroidspule aufweist, wobei die Stromversorgungseinrichtung (10) einen DC/DC Wandler umfasst, wobei die Toroidspule einen paramagnetischen und/oder diamagnetischen Kern aufweist. Die Erfindung betrifft weiter einen Stromrichter mit einer derartigen Strommessvorrichtung. Ferner betrifft die Erfindung ein Verfahren zur Messung eines zu messenden Stroms mit einer derartigen Strommessvorrichtung oder mittels eines derartigen Stromrichters, wobei die Messsignale der Hallsensoren mittels der Addierschaltung addiert werden und eine zum zu messenden Strom proportionale Spannung erzeugt wird, wobei mittels der Subtrahierschaltung ein Offset derart von der zum zu messenden Strom proportionale Spannung subtrahiert wird, dass sich eine referenzierte Spannung ergibt, bei der die zum zu messenden Strom proportionale Spannung auf eine vorgegebene Bezugsmasse referenziert wird, wobei mittels der spannungsgesteuerten Stromquelle in Abhängigkeit von der referenzierten Spannung ein Ausgangsstrom mit einem zum zu messenden Strom vorgegebenen Übersetzungsverhältnis erzeugt wird.

## Patentansprüche

1. Strommessvorrichtung (1) zur Erzeugung eines zu einem zu messenden Strom (I) proportionalen Ausgangsstroms (I_{Ausg}), wobei die Strommessvorrichtung (1) mindestens zwei auf einer Kreisbahn (21) angeordnet Hallsensoren (2) umfasst, wobei die Hallsensoren (2) bezogen auf den Mittelpunkt (M) der Kreisbahn (21) gleich ausgerichtet sind, wobei die Strommessvorrichtung (1) eine Addierschaltung (11) zum Summieren von Messignalen (3) der Hallensensoren (2) aufweist, wobei die Strommessvorrichtung (1) eine Subtrahierschaltung (12) zur Beseitigung eines Offsets aufweist, **dadurch gekennzeichnet, dass** die Strommessvorrichtung (1) eine spannungsgesteuerte Stromquelle (13) aufweist, wobei zur Versorgung der Hallsensoren (2) die Strommessvorrichtung (1) eine Stromversorgungseinrichtung (10) mit einer Toroidspule aufweist, wobei die Stromversorgungseinrichtung (10) einen DC/DC Wandler umfasst, wobei die Toroidspule einen paramagnetischen und/oder diamagnetischen Kern aufweist.

2. Strommessvorrichtung (1) nach Anspruch 1, wobei die spannungsgesteuerte Stromquelle (13) auf einer Basis von einem Operationsverstärker mit einer Transistor-Endstufe des Typs B ausgebildet ist.

3. Strommessvorrichtung (1) nach einem der Ansprüche 1 oder 2, wobei die Strommessvorrichtung (1) mindestens acht Hallsensoren (2) aufweist.

4. Stromrichter (4) mit einer Strommessvorrichtung (1) nach einem der Ansprüche 1 bis 3.

5. Verfahren zur Messung eines zu messenden Stroms (I) mit einer Strommessvorrichtung (1) nach einem der Ansprüche 1 bis 3 oder mittels eines Stromrichters (4) nach Anspruch 4, wobei in einem ersten Schritt die Messsignale (3) der Hallsensoren (2) mittels der Addierschaltung (11) addiert werden und eine zum zu messenden Strom proportionale Spannung (U) erzeugt wird, wobei in einem zweiten Schritt mittels der Subtrahierschaltung (12) ein Offset derart von der zum zu messenden Strom proportionale Spannung (U) subtrahiert wird, dass sich eine referenzierte Spannung (U_{ref}) ergibt, bei der die zum zu messenden Strom proportionale Spannung (U) auf eine vorgegebene Bezugsmasse referenziert wird, wobei in einem dritten Schritt mittels der spannungsgesteuerten Stromquelle (13) in Abhängigkeit von der referenzierten Spannung (U_{ref}) ein Ausgangsstrom (I_{Ausg}) mit einem zum zu messenden Strom (I) vorgegebenen Übersetzungsverhältnis erzeugt wird.

## Claims

1. Current-measuring device (1) for generating an output current (I_{Outp}) which is proportional to a current (I) to be measured, wherein the current measuring device (1) comprises at least two Hall sensors (2) arranged on a circular path (21), wherein the Hall sensors (2) are oriented identically in relation to the centre point (M) of the circular path (21), wherein the current measuring device (1) has an adding circuit (11) for summing measurement signals (3) of the Hall sensors (2), wherein the current measuring device (1) has a subtracting circuit (12) for eliminating an offset, **characterised in that** the current measuring device (1) has a voltage-controlled current source (13), wherein in order to supply the Hall sensors (2) the current measuring device (1) has a power supply facility (10) with a toroidal coil, wherein the power supply facility (10) comprises a DC/DC converter, wherein the toroidal coil has a paramagnetic and/or diamagnetic core.

2. Current measuring device (1) according to claim 1, wherein the voltage-controlled current source (13) is embodied on a basis of an operational amplifier with a transistor output stage of type B.

3. Current measuring device (1) according to one of claims 1 or 2, wherein the current measuring device (1) has at least eight Hall sensors (2).

4. Current converter (4) with a current measuring device (1) according to one of claims 1 to 3.

5. Method for measuring a current (I) to be measured with a current measuring device (1) according to one of claims 1 to 3 or by means of a current converter (4) according to claim 4, wherein in a first step the measuring signals (3) of the Hall sensors (2) are added by means of the adding circuit (11) and a voltage (U) which is proportional to the current to be measured is generated, wherein in a second step, an offset is subtracted from the voltage (U) which is proportional to the current to be measured by means of the subtracting circuit (12) so that a referenced voltage (U_{ref}) is produced, in which the voltage (U) which is proportional to the current to be measured is referenced to a predetermined reference mass, wherein in a third step, an output current (I_{Outp}) with a transformation ratio, which is predetermined with respect to the current (I) to be measured, is generated by means of the voltage-controlled current source (13) as a function of the referenced voltage (U_{ref}).

## Revendications

1. Installation (1) de mesure du courant pour la production d'un courant (I_{Ausg}) de sortie proportionnel à un courant (I) à mesurer, dans laquelle l'installation (1) de mesure du courant comprend au moins deux capteurs (2) de Hall montés sur une orbite (21), dans laquelle les capteurs (2) de Hall sont, rapporté au centre (M) de l'orbite (21), orientés de la même façon, dans laquelle l'installation (1) de mesure du courant a un circuit (11) d'addition pour faire la somme de signaux (3) de mesure des capteurs (2) de Hall, dans laquelle l'installation (1) de mesure du courant a un circuit (12) de soustraction pour éliminer un décalage, **caractérisé en ce que** l'installation (1) de mesure du courant a une source (13) de courant commandée en tension, dans laquelle, pour l'alimentation des capteurs (2) de Hall, l'installation (1) de mesure du courant a un dispositif (10) d'alimentation en courant ayant une bobine toroïdale, dans laquelle le dispositif (10) d'alimentation en courant comprend un transformateur courant continu / courant continu, dans laquelle la bobine toroïdale à un noyau paramagnétique et/ou diamagnétique.

2. Installation (1) de mesure du courant suivant la revendication 1, dans laquelle la source (13) de courant commandée en tension est constituée sur une base d'un amplificateur opérationnel ayant un étage d'extrémité transistor du type B.

3. Installation (1) de mesure du courant suivant l'une des revendications 1 ou 2, dans laquelle l'installation (1) de mesure du courant a au moins huit capteurs (2) de Hall.

4. Convertisseur (4) ayant une installation (1) de mesure du courant suivant l'une des revendications 1 à 3.

5. Procédé de mesure d'un courant (I) à mesurer par une installation (1) de mesure du courant suivant l'une des revendications 1 à 3 ou au moyen d'un convertisseur (4) suivant la revendication 4, dans lequel, dans un premier stade, on additionne les signaux (3) de mesure des capteurs (2) de Hall au moyen du circuit (11) d'addition et on produit une tension (U) proportionnelle au courant à mesurer, dans lequel, dans un deuxième stade, on soustrait, au moyen du circuit (12) de soustraction, un écart à la tension (U) proportionnelle au courant à mesurer de manière à obtenir une tension (U_{ref}) référencée, pour laquelle la tension (U) proportionnelle au courant à mesurer est référencée sur une masse de référence donnée à l'avance, dans lequel, dans un troisième stade, au moyen de la source (13) de courant commandée en tension, on produit, en fonction de la tension (U_{ref}) référencée, un courant (I_{Ausg}) de sortie ayant un rapport de multiplication donné à l'avance avec le courant (I) à mesurer.
